# DEMANDE DE BREVET EUROPEEN

(11) **EP 1 437 378 A1**
(43) Date de publication de la demande: **14.07.2004**
(21) Numéro de dépôt: 04290013.4
(22) Date de dépôt: 06.01.2004
(51) Int. Cl.: C08J 11/24, C08G 18/42

(54) **Procédé de valorisation de déchets de materiaux à base de résine époxyde**

(30) Priorité: 09.01.2003 FR 0300199
(71) Demandeur: Electricité de France, 75008 Paris (FR)
(72) Inventeur: Hita, Alain, 77300 Fontainebleau (FR); Lahitte, Claude, 77250 Moret-sur-Loing (FR); Roiu, Fabienne, 29660 Saint-Martin-des-Champs (FR); Tersac, Gilles, 91750 Champcueil (FR); Durand, Gérard, 78230 Le Pecq (FR); Caudron, Jean-Charles, 49460 Feneu (FR)
(74) Mandataire: Vercaemer, Laurence

(57) **Abrégé**

L'invention concerne un procédé de valorisation de déchets de matériaux à base de résine époxyde, comprenant une étape de glycolyse du matériau à une température supérieure à 225°C, en présence d'au moins un polyalcool et de 10 à 25% de KOH en poids par rapport au poids de matériau.

## Description

La présente invention concerne un procédé de valorisation de déchets de matériaux à base de résine époxyde, en particulier les circuits imprimés utilisés en électronique.

Dans le domaine de l'électronique, les plastiques thermodurcissables, tels que des résines époxydes, sont utilisés notamment pour leur haute stabilité thermique et leurs propriétés d'isolation.

Les résines époxydes actuellement utilisées sur le marché sont pour 95% des résines époxydes DGEBA (diglycidyléther du bisphénol A) à base de bisphénol A (BPA, A pour acétone) et d'épichlorhydrine (ECH). Ces résines sont synthétisées en présence de soude. Des résines époxydes aux propriétés ignifugeantes peuvent être préparées en condensant de l'épichlorine (ECH) avec du BPA et du tétrabromobisphénol A (TBBA). L'homme de l'art connaît ce matériau sous l'acronyme FR-4 pour « Flame Retardant », retardateur de flamme, mais on peut aussi citer les résines époxydes de type FR-3, FR-5, CEM-1 et CEM-3.

Dans le domaine de l'électronique, la plupart des circuits imprimés sont des matériaux composites réalisés à base de résines époxydes et de fractions inorganiques comme des éléments métalliques ou des fibres de verre. On entend par matériau à base de résine époxyde, un matériau comprenant au moins en partie une résine époxyde. La structure physique et chimique de ces circuits imprimés peut en outre être très variable selon le type de circuit.

Le recyclage de déchets à base de ces résines époxydes est difficile car celles-ci ne peuvent ni être reliquéfiées, ni redissoutes. Le problème est particulièrement épineux quand le matériau est composite, c'est-à-dire qu'il associe au polymère thermodurcissable des fractions solides inorganiques comme des fibres de verre et des métaux, ce qui est le cas des circuits imprimés. Par ailleurs, la structure des circuits imprimés étant très variable selon le type de circuit, il est très difficile de mettre au point un procédé universel pour le traitement de leurs déchets.

C'est ainsi que généralement, la mise en décharge et l'incinération sont les seules alternatives offertes à l'industrie. Or le tonnage de ce type de déchets ne cesse de croître et la mise en décharge et l'incinération ne représentent pas des solutions satisfaisantes d'un point de vue environnemental. En effet, leur incinération engendre l'émission de gaz nocifs et ils ne se dégradent pas naturellement après leur mise en décharge.

Cependant, de nouvelles contraintes réglementaires se mettent en place pour y remédier, et des propositions de directives ont même été adoptées à ce sujet en Europe.

Un moyen idéal pour pallier le problème est la dépolymérisation de ce type de plastiques résines par voie chimique. En plus de la possibilité de récupération des matières inorganiques, cela présente en effet l'avantage de conduire à de nouvelles matières premières directement utilisables grâce à la synthèse de nouveaux produits pour des applications pouvant être différentes de celles d'origine. Ainsi, des éléments métalliques ou des fibres de verres issues de circuits imprimés pourraient être recyclées dans de nouvelles applications.

Toutefois, bien qu'intéressante d'un point de vue théorique, la dépolymérisation s'avère être une voie particulièrement difficile à mettre en oeuvre, surtout lorsqu'il s'agit de traiter des résines époxydes qui, de façon inhérente, possèdent des structures très complexes et très variables.

La demande de brevet WO 00/12598 décrit déjà une dépolymérisation de déchets de matériaux à base de résine époxyde par solvolyse à une température aux alentours de 350°C, en présence d'un hydrocarbure aromatique partiellement hydrogéné, en particulier la tétraline. Cependant, cette solvolyse présente le désavantage d'être relativement longue, de nécessiter un équipement sous pression et la valorisation des produits de dépolymérisation apparaît problématique.

Une autre voie de solvolyse de déchets de matériaux à base de résine époxyde a été proposée par la Demanderesse dans la demande de brevet FR 2 811 246. Dans les exemples 3 à 5 de ce document la Demanderesse a déjà décrit la solvolyse de résines époxydes à 245°C, en présence de diéthylèneglycol (DEG) dans un rapport DEG : résine de 5 : 1 en poids et de tétrabutylorthotitanate (TBT) à 0,5% en poids sur le poids de résine traitée.

Toutefois, cette voie s'est révélée non universelle, car le rendement de la réaction de solvolyse est quantitatif pour certains types de circuits imprimés à base de résines époxydes, mais pas pour d'autres.

La demande de brevet WO 01/25317 décrit également un procédé de solvolyse de déchets de matériaux à base de résines époxydes à une température généralement inférieure à 100°C, en présence d'un solvant organique et d'un catalyseur de décomposition. Les solvants organiques préconisés sont à base alcoolique, amide, éther ou cétone, et les catalyseurs privilégies sont à base de métal alcalin. Parmi la grande variété de solvants et de catalyseurs proposés, les solvants tels que la cyclohexanone (CHON) et la N-méthyl-2-pyrrolidone (NMP) en combinaison avec KOH, NaCl ou Na₂CO, à 300% en poids sur le poids de la résine traitée, sont privilégiés par les auteurs. Dans le meilleur cas, ce procédé arrive à dépolymériser puis dissoudre 93,5% de la résine époxyde dans un matériau composite spécifique avec le couple N-methyl-2-pyrrolidone (NMP) et polyéthylèneglycol (PEG) en présence de KOH à 300% en poids.

En revanche, les matériaux inorganiques récupérés ne sont pas complètement débarrassés des résines époxydes et les éléments métalliques ou les fibres de verres récupérés ne sont pas dans un état permettant un recyclage immédiat, c'est-à-dire sans traitement additionnel.

Un des buts de la présente invention est donc de fournir un procédé rapide et efficace pour la valorisation de déchets de matériaux à base de résines époxydes, qui permette un recyclage direct de tous les matériaux constituant le matériau composite. En particulier, un but de l'invention est de fournir un procédé susceptible de traiter tous les types de circuits imprimés provenant du démantèlement d'ordinateurs usagés.

Un autre but de la présente invention est un procédé pour la fabrication de mousses polyuréthanne à partir de produits issus du traitement de déchets de matériaux à base de résines époxydes.

Selon l'un de ses aspects, l'invention concerne donc un procédé de valorisation de matériau à base de résine époxyde, comprenant une étape de glycolyse du matériau à une température supérieure à 225°C, en présence d'au moins un polyalcool et de 10 à 25% de KOH en poids par rapport au poids de matériau.

Les conditions de mise en oeuvre de ce procédé telles que la température de réaction, les solvants et réactifs, ont été définies par la Demanderesse au prix de nombreux efforts et permettent d'obtenir des résultats améliorés, surprenants et inégalés à ce jour.

En effet, le procédé selon l'invention permet de dépolymériser plus de 93,5% et voire même jusqu'à 100% de la résine époxyde contenue dans les déchets de matériaux composites traités.

Par ailleurs, les fractions inorganiques récupérées à partir de ces matériaux composites sont suffisamment débarrassées de résine époxyde et sont dans un état permettant leur recyclage immédiat vers d'autres applications.

Le procédé selon l'invention fournit également de nombreux avantages par rapport à l'art antérieur.

En effet, le procédé selon l'invention est universel puisqu'il permet de traiter tous les types de circuits imprimés actuellement utilisés sur le marché.

Le procédé selon l'invention peut également avantageusement être conduit à pression ambiante et ne requiert pas un réacteur sous pression.

De plus, les conditions de mise en oeuvre du procédé permettent une dépolymérisation des matériaux composites à base de résine époxyde dans une durée inférieure à 4h, de préférence comprise entre 1 et 3h, et plus préférentiellement dans une durée environ égale à 2h30.

Par ailleurs, l'utilisation de KOH comme réactif est particulièrement avantageuse en raison de son prix peu élevé.

Enfin, les déchets de matériaux à base de résine époxyde peuvent être totalement recyclés et donc valorisés.

Ainsi, à l'issue du procédé, les produits obtenus sont d'une part un glycolysat liquide, et d'autre part des solides, débarrassés de résine époxyde.

Les produits solides débarrassés de résine époxyde peuvent être directement recyclés, sans traitement ultérieur.

Les glycolysats liquides récupérés peuvent eux aussi être revalorisés en matériaux polyuréthannes, et notamment en mousses rigides grâce au procédé selon l'invention.

En ce qui concerne la température de réaction, l'étape de glycolyse selon l'invention peut avantageusement être conduite à une température supérieure à 225°C et inférieure ou égale à 400°C, de préférence supérieure ou égale à 230°C et inférieure à 265°C, et plus préférentiellement à une température d'environ 245°C.

L'étape de glycolyse selon l'invention est conduite en présence de tout polyalcool. On entend par polyalcool, tout diol ou triol ou polyalcool de fonctionnalité supérieure. Des exemples de polyalcools adaptés sont : l'éthylèneglycol, les polyétylèneglycols comme les di-, tri- tétra-éthylèneglycols et les PEG 200, 400, 600, le propylèneglycol et les polypropylèneglycols, le 1,4-butanediol, le 1,6-hexanediol, le néopentylglycol, le glycérol, le triméthylolpropane, le pentaérythritol. Ces exemples ne sont pas limitatifs et l'homme du métier reconnaîtra que d'autres polyalcools peuvent être utilisés dans le procédé selon l'invention.

Parmi les polyalcools adaptés, il est particulièrement avantageux de choisir un polyéthylèneglycol. Des exemples de polyéthylèneglycols adaptés sont : le diéthylèneglycol ou le triéthylèneglycol et de préférence le triéthylèneglycol.

Ce polyalcool est de préférence présent dans un rapport polyalcool : matériau en poids de 2 : 1 à 15 : 1, de préférence de 4 : 1 à 10 : 1, et plus préférentiellement de 5 : 1.

D'après un autre mode de réalisation du procédé selon l'invention, l'étape de glycolyse est conduite en présence de 10 à 20% de KOH, de préférence, en présence de 15% de KOH en poids par rapport au poids de matériau.

Dans un mode de réalisation particulier, le procédé de l'invention comprend en outre et préalablement à l'étape de glycolyse, une étape de broyage du matériau à base de résine époxyde à traiter. Cette étape de broyage, dont le but est de réduire la taille des morceaux de matériaux époxydes à traiter, n'est toutefois pas indispensable. En effet, la Demanderesse a constaté que la taille des morceaux de matériau époxyde n'affectait pas la cinétique de la réaction. Par contre, l'élimination effective de la résine époxyde dans les couches internes du circuit imprimé est plus difficile dans le cas des morceaux de grande taille. Une taille de l'ordre du cm² est préférable.

Le procédé de l'invention peut également comprendre, simultanément à l'étape de glycolyse, une étape de distillation des produits issus de la dégradation du polyalcool. Ces produits sont notamment de l'eau et du 1,4-dioxane. Sans vouloir être liée par une quelconque théorie, la Demanderesse a constaté que la distillation de ces produits permet d'éviter une diminution de la température du mélange réactionnel et donc de la vitesse de réaction.

On peut également réaliser une agitation du milieu réactionnel pendant l'étape de glycolyse. Pour ce faire, tout type d'agitation peut être utilisé, notamment une agitation à pales. Cependant, la conduite de la réaction est plus aisée lorsque le module par pales monté sur la tige d'agitation est remplacé par un panier perforé et fermé contenant les morceaux de circuits imprimés. Une agitation, de préférence intermittente, permet une bonne circulation du liquide solvolysant à travers les échantillons, tout en maintenant l'intégrité des tissus de verre constitutifs et en permettant l'immersion totale pendant toute la durée de la réaction.

À l'issue de l'étape de glycolyse du procédé selon l'invention, il peut être intéressant de prévoir une étape ultérieure de séparation des produits solides et du glycolysat liquide obtenus.

Il peut arriver qu'à l'issue de la séparation solide-liquide, les fractions inorganiques soient encore imprégnées de glycolysat. Dans ces conditions, l'élimination totale du glycolysat peut être obtenue par lavage. Le solvant de lavage doit être compatible avec le glycolysat. On entend par solvant de lavage compatible avec le glycolysat, un solvant miscible en toutes proportions avec le glycolysat. Ce solvant compatible peut être le polyalcool lui-même ou un solvant polaire comme le diméthylsulfoxyde, le diméthylformamide ou l'alcool benzylique. Ce solvant de lavage peut être éliminé par rinçage avec un solvant de faible température d'ébullition comme l'acétone ou le méthanol. Enfin, ce dernier solvant de rinçage peut être éliminé par séchage.

Selon un autre de ses aspects, l'invention concerne un procédé de recyclage du glycolysat, obtenu à l'issue de la glycolyse selon l'invention, pour la préparation de mousses polyuréthannes.

La préparation de mousses polyuréthanne peut être réalisée de manière classique, bien connue de l'homme du métier.

La Demanderesse a néanmoins constaté que l'indice d'hydroxyle des glycolysats du matériau époxyde est trop élevé pour permettre directement la préparation de mousses polyuréthannes de bonne qualité. La distillation ultérieure des glycols libres excédentaires permettrait d'abaisser l'indice d'hydroxyle, mais le polyol résultant devient alors excessivement visqueux.

C'est pourquoi, il est indiqué de réaliser une seconde glycolyse d'un matériau à base de polyéthylènetéréphtalate, par le premier glycolysat récupéré à l'issue de l'étape de glycolyse du matériau à base de résine époxyde, avant la préparation de mousses.

Dans l'un de ses aspects, l'invention concerne donc un procédé comprenant les étapes de :
- glycolyse d'un matériau à base de polyéthylènetéréphtalate, éventuellement préalablement broyé, par un premier glycolysat, récupéré à l'issue de l'étape de glycolyse, afin d'obtenir un second glycolysat,
- préparation de mousse polyuréthanne à partir du second glycolysat.

Lorsqu'il s'agit de recycler des circuits imprimés portant des composants électroniques, un mode de réalisation particulier du procédé selon l'invention comprend avantageusement les étapes successives de :
- retirer les composants électroniques du circuit imprimé,
- éventuellement découper ou broyer le circuit imprimé jusqu'à atteindre des morceaux de surface comprise entre 20 cm² et 1 mm²,
- glycolyser le circuit imprimé à une température supérieure à 225°C, en présence d'au moins un polyalcool et de 10 à 25% de KOH en poids par rapport au poids de matériau pour obtenir un premier glycolysat,
- éventuellement distiller les produits issus de la dégradation du polyalcool, concomitamment à l'étape de glycolyse,
- séparer les produits solides et du premier glycolysat liquide obtenus à l'issue de l'étape de glycolyse,
- laver les produits solides à l'aide d'un solvant compatible avec le glycolysat,
- glycolyse d'un matériau à base de polyéthylènetéréphtalate (PET), éventuellement préalablement broyé, par le premier glycolysat obtenu à l'issue de l'étape de glycolyse du matériau à base de résine époxyde pour obtenir un second glycolysat,
- préparation de mousse polyuréthanne à partir du second glycolysat.

Cette manière de procéder présente l'avantage de rendre le glycolysat de matériau époxyde propre à la fabrication de mousses polyuréthannes, tout en retraitant des déchets à base de PET.

Les mousses polyuréthannes obtenues présentent alors une bonne stabilité dans le temps et une bonne tenue.

L'invention sera mieux comprise à l'aide des exemples qui suivent et qui sont donnés à titre d'illustration, sans pour autant limiter l'invention à ces simples illustrations.

Les exemples qui suivent ont été réalisés sur des plaques de circuits imprimés de même nature, dont la solvolyse par le DEG catalysée par le TBT, telle que décrite dans la demande de brevet FR 2 811 246, n'est pas satisfaisante. Les résultats ont été validés par des essais sur des circuits imprimés mélangés provenant d'ordinateurs mis au rebut.

### EXEMPLE 1 : GLYCOLYSE DE CIRCUITS IMPRIMES SELON L'INVENTION DEG/KOH SANS BROYAGE PREALABLE DES CIRCUITS IMPRIMES

Mode opératoire : on réalise la glycolyse de circuits imprimés en présence de diéthylèneglycol (DEG) et KOH selon l'invention. Pour ce faire, on place 50,7 g de morceaux, découpés (surface moyenne 5 cm²) dans une plaque de circuit imprimé multicouche, dans un réacteur, équipé d'un agitateur à pales et d'une colonne de distillation. On ajoute du diéthylèneglycol de sorte à avoir un rapport diéthylèneglycol : circuit imprimé de 5 : 1 en poids (253,5 g de DEG). On ajoute 15% en poids par rapport au poids de circuit imprimé de KOH solide (7,6 g) et on chauffe sous atmosphère d'azote à 245°C pendant 2h30.

Après refroidissement, une séparation des solides et des liquides est effectuée par essorage. La fraction solide est alors lavée avec 150 ml de diméthylsulfoxyde, essorée, puis lavée encore deux fois avec 150 ml d'acétone. Elle est enfin séchée à 60°C. On récupère ainsi 10 g de métaux, principalement du cuivre, et 20 g de fibres de verre.

Résultats : à l'issue de la glycolyse, la résine époxyde est totalement dépolymérisée et dissoute dans le glycolysat (solubilité de 100% de la résine), les plaques de cuivre et les fibres de verre récupérées sont propres, complètement débarrassées de résine époxyde, et peuvent être directement recyclées vers de nouvelles applications.

Le glycolysat récupéré peut être réutilisé pour la fabrication de mousses polyuréthannes.

### EXEMPLE 2 : GLYCOLYSE DE CIRCUITS IMPRIMES SELON L'INVENTION DEG/KOH AVEC BROYAGE PREALABLE DES CIRCUITS IMPRIMES

Mode opératoire : on broie 50 g de circuit imprimé (surfaces après broyage inférieures à 25 mm²) et on réalise la glycolyse du broyat obtenu dans les conditions de l'exemple 1.

Résultats : à l'issue de la glycolyse, la résine époxyde est totalement dépolymérisée et dissoute dans le glycolysat (solubilité de 100% de la résine), les fibres récupérées sont propres, complètement débarrassées de résine époxyde, et peuvent être directement recyclées vers de nouvelles applications. Le glycolysat récupéré peut être réutilisé pour la fabrication de mousses polyuréthannes.

### EXEMPLE 3 : GLYCOLYSE DE CIRCUITS IMPRIMES SELON L'INVENTION TEG/KOH DES CIRCUITS IMPRIMES

Mode opératoire : dans les mêmes conditions que celles de l'exemple 1, on réalise la glycolyse de 49,9 g circuits imprimés, à la différence qu'on utilise du triéthylèneglycol (TEG) et KOH.

Résultats : à l'issue de la glycolyse, la résine époxyde est totalement dépolymérisée et dissoute (solubilité de 100% de la résine) dans le glycolysat, les fibres récupérées sont propres, complètement débarrassées de résine époxyde, et peuvent être directement recyclées vers de nouvelles applications. Le glycolysat récupéré peut être réutilisé pour la fabrication de mousses polyuréthannes.

### EXEMPLE 4 : GLYCOLYSE DE CIRCUITS IMPRIMES SELON L'INVENTION TEG/KOH AVEC AGITATION PAR PANIER DES CIRCUITS IMPRIMES

Mode opératoire : on réalise la glycolyse de circuits imprimés en présence de triéthylèneglycol (TEG) et KOH selon l'invention. Pour ce faire, on place 100 g de circuit imprimé dans un panier perforé monté sur la tige d'agitation d'un réacteur équipé d'une colonne de distillation. On ajoute du triéthylèneglycol de sorte à avoir un rapport triéthylèneglycol : circuit imprimé de 5 : 1 en poids (500 g de TEG). On ajoute 15% en poids par rapport au poids de circuit imprimé de KOH solide (15 g) et on chauffe sous atmosphère d'azote à 245°C pendant 2h30 et sous agitation intermittente.

Résultats : à l'issue de la glycolyse, la résine époxyde est totalement dépolymérisée et dissoute dans le glycolysat, les tissus de verre récupérés sont propres, non défibrés, complètement débarrassés de résine époxyde, et peuvent être directement recyclés vers de nouvelles applications. Le glycolysat récupéré peut être réutilisé pour la fabrication de mousses polyuréthannes.

### EXEMPLE 5 : EXEMPLE COMPARATIF VIS-A-VIS DE LA DEMANDE DE BREVET FR 2 811 246

Le but de cet exemple est de comparer le procédé de l'art antérieur décrit dans la demande de brevet FR 2 811 246 au procédé selon l'invention.

On réalise la glycolyse d'un circuit imprimé selon les conditions décrites dans la demande de brevet FR 2 811 246 :

Mode opératoire : Dans un réacteur agité, surmonté d'un réfrigérant et soumis à un balayage d'azote, on place 54,9 g de circuit imprimés et du DEG de sorte à avoir un rapport DEG : circuit imprimé de 5 : 1 en poids. On ajoute du tétrabutylorthotitanate (TBT) à 0,5% en poids sur le poids de circuit imprimé. Le réacteur est chauffé à 245°C pendant 11h15.

Résultats : à l'issue de la glycolyse et après filtration du glycolysat, on récupère des fibres qui sont partiellement libérées, certains morceaux de circuit imprimé ne sont même pas attaqués et les fibres récupérées ne peuvent pas être directement recyclées.

### EXEMPLE 6 : EXEMPLES COMPARATIFS VIS-A-VIS DE LA DEMANDE DE BREVET WO 01/25317

Le but du présent exemple est de démontrer que des effets surprenants et améliorés sont obtenus dans les conditions de l'invention par rapport à celles privilégiées dans la demande WO 01/25317.

### Exemple 6.a : Nature du solvant

La demande de brevet WO 01/25317 préconise l'emploi de N-méthyl-2-pyrrolidone (NMP) dans la glycolyse de circuits imprimés. L'exemple qui suit a pour but de démontrer que des effets améliorés sont obtenus en utilisant polyalcool plutôt que NMP.

On réalise la glycolyse de circuits imprimés contenant des plaques de cuivre en présence de la N-méthyl-2-pyrrolidone (NMP) et KOH.

Pour ce faire, on place 50,2 g de circuit imprimé dans un réacteur, équipé d'un agitateur à pales. On ajoute de la N-méthyl-2-pyrrolidone (NMP) de sorte à avoir un rapport NMP : circuit imprimé de 5 : 1 en poids (251 g de NMP). On ajoute 15% en poids par rapport au poids de circuit imprimé de KOH solide (7,5 g) et on chauffe sous reflux à ébullition (202°C) pendant 2h30.

Résultats : à l'issue de la solvolyse, la résine époxyde est quasi totalement dépolymérisée et dissoute dans le glycolysat, toutefois, les plaques de cuivre sont partiellement dégradées et le solvolysat récupéré est inapte pour la fabrication de mousses polyuréthannes.

En comparaison avec les exemples 1 à 4 selon l'invention, cet exemple montre l'importance du choix d'un polyalcool, puisque, contrairement à la NMP, le choix d'un polyalcool permet de réutiliser directement les plaques de cuivre et de valoriser le glycolysat obtenu.

### Exemple 6.b : Nature du composé réactif basique :

L'exemple qui suit a pour but de démontrer que des effets améliorés sont obtenus en utilisant KOH plutôt que NaOH.

On réalise la glycolyse de circuits imprimés en présence de diéthylèneglycol (DEG) et NaOH.

Pour ce faire, on place 52 g de circuit imprimé dans un réacteur, équipé d'un agitateur à pales. On ajoute du DEG de sorte à avoir un rapport DEG : circuit imprimé de 5 : 1 en poids (260 g de DEG). On ajoute 15% en poids par rapport au poids de circuit imprimé de NaOH solide (7,8 g) et on chauffe sous reflux à ébullition pendant 2h30.

Résultats : à l'issue de la glycolyse, les fibres de verre sont sales et ne sont pas utilisables directement.

En comparaison avec les exemples 1 à 4 selon l'invention, cet exemple montre l'importance du choix de KOH comme réactif basique par rapport à NaOH, puisque, le choix spécifique de KOH permet d'obtenir des fibres propres qui sont réutilisables directement.

### Exemple 6.c : Quantité de KOH

Le but de cet exemple est de démontrer que la quantité de KOH influence de façon importante la glycolyse de circuits imprimés à base de résine époxyde. Le procédé selon l'invention est réalisé en présence de 10 à 25% en poids de KOH tandis que la demande de brevet WO 01/25317 préconise une quantité de 300% de KOH par rapport au poids de résine époxyde.

On réalise quatre glycolyses de circuits imprimés à base de résine époxyde dans les conditions de l'exemple 3, sauf que les quantités de KOH sont respectivement 2, 5, 10 et 25% en poids.

Résultats : avec 2 et 5% de KOH, les circuits imprimés sont à peine dépolymérisés. Avec 10% et 25% et de préférence 15% de KOH, le rendement est satisfaisant. Au delà de 25%, les fibres obtenues sont colorées en marron et le taux de dégradation du solvant est important.

En comparaison avec les exemples 1 à 4 selon l'invention, cet exemple démontre qu'une quantité de 2 à 5% de KOH, ne permet pas d'obtenir les résultats satisfaisants de l'invention. Par ailleurs une trop grande quantité de KOH, telle que préconisée dans l'art antérieur, risque d'être néfaste pour les fibres de verre.

### Exemple 6.d : Influence de la température

La demande WO 01/25317 privilégie des températures entre 60 et 100°C. Dans le but de montrer que des effets améliorés sont obtenus dans les gammes de températures supérieures à 225°C, on réalise quatre glycolyses de circuits imprimés à base de résine époxyde, dans les conditions de l'exemple 4, avec des températures de 200, 225, 245 et 265°C

Résultats : la résine époxyde n'est que très peu dissoute à 200°C. A 225°C, le rendement est encore partiel. En revanche, au-delà de 225°C des résultats satisfaisants sont obtenus. Des résultats particulièrement avantageux sont obtenus à 245°C. Cependant, à partir de 265°C, bien que les fibres récupérées soient colorées en marron, elle restent recyclables.

On observe également à partir de 265°C que le taux de dégradation du solvant est plus important.

### EXEMPLE 7 : PREPARATION DE MOUSSES POLYURETHANNES A PARTIR DU GLYCOLYSAT DE MATÉRIAU EPDXYDE OBTENU A L'ISSUE DU PROCEDE SELON L'INVENTION

### Exemple 7.a : Glycolyse de PET

On neutralise 200 g d'un glycolysat obtenu dans les conditions de l'exemple 4 (TEG/KOH) par 4 ml de H₃PO₄ à 85%.

Les sels de potassium précipités sont éliminés par filtration. L'indice d'hydroxyle du glycolysat est égal à 682 mg KOH/g, correspondant à une concentration en groupes OH égale à 12,2 meq/g.

On mélange, dans un réacteur agité, surmonté d'une colonne de distillation, 100 g de ce glycolysat et 50 g de polyéthylènetéréphtalate (PET) et on chauffe sous atmosphère d'azote le mélange réactionnel à 245°C. La phase solide a totalement disparu après 15 minutes de réaction et on maintient encore le chauffage pendant une heure. 0,96 g de distillat ont été éliminés. Apres refroidissement, le polyol se présente sous forme d'un liquide moyennement visqueux. L'indice d'hydroxyle est égal à 440 mg KOH/g, correspondant à une concentration en groupes OH égale à 7,9 meq/g.

### Exemple 7.b- Préparation de mousses polyuréthanne

On prépare des mousses polyuréthanne à partir du polyol obtenu dans l'exemple 7.a.

Dans une première étape, on ajoute à 40 g de polyol des additifs classiques :
- Eau : 0,4 g (agent moussant chimique) ;
- HCFC 141b : 8 g (agent moussant physique) ;
- SR 242 : 0,8 g (tensioactif) ;
- DMCHA : 0,6 g (catalyseur).

Le mélange est homogénéisé.

On ajoute alors 53,3 g d'un PMDI (isocyanate, fonctionnalité 2,5, dont la concentration en groupes NCO est égale à 7,4 meq/g), ce qui correspond à 10% d'excès de fonctions isocyanate. Le mélange est immédiatement agité par une pale tournante à 2000 tours / minute, pendant 30 secondes.

Les temps caractéristiques suivants ont été obtenus : temps de crème : 60 secondes, temps de fil : 113 secondes, temps hors-poisse : 120 secondes.

La mousse obtenue a une cellularité fine. Sa densité est égale à 0,0315.

## Revendications

1. Procédé de valorisation de déchets de matériaux à base de résine époxyde, comprenant une étape de glycolyse du matériau à une température supérieure à 225°C, en présence d'au moins un polyalcool et de 10 à 25% de KOH en poids par rapport au poids de matériau.

2. Procédé selon la revendication 1, dans lequel l'étape de glycolyse est conduite à une température supérieure à 225°C et inférieure à 400°C, de préférence supérieure ou égale à 230°C et inférieure à 265°C, et plus préférentiellement à une température d'environ 245°C.

3. Procédé selon l'une ou l'autre des revendications 1 et 2, dans lequel l'étape de glycolyse est conduite en présence de 10 à 20% de KOH, de préférence, en présence de 15% de KOH en poids par rapport au poids de matériau.

4. Procédé selon l'une quelconque des revendications 1 à 3, dans lequel le rapport polyalcool : matériau en poids va de 2 : 1 à 15 : 1, de préférence de 4 : 1 à 10 : 1, et plus préférentiellement est de 5 : 1.

5. Procédé selon l'une quelconque des revendications 1 à 4, dans lequel on réalise une agitation, notamment par pales ou par panier, du milieu réactionnel pendant l'étape de glycolyse.

6. Procédé selon l'une quelconque des revendications 1 à 5, dans lequel l'étape de glycolyse est conduite à pression ambiante.

7. Procédé selon l'une quelconque des revendications 1 à 6, dans lequel l'étape de glycolyse est conduite en présence d'un polyéthylèneglycol choisi parmi le diéthylèneglycol ou le triéthylèneglycol, de préférence en présence de triéthylèneglycol.

8. Procédé selon l'une quelconque des revendications 1 à 7, dans lequel l'étape de glycolyse est réalisée en une durée inférieure à 4h, de préférence comprise entre 1 et 3h et plus préférentiellement en une durée d'environ 2h30.

9. Procédé selon l'une quelconque des revendications 1 à 8, dans lequel le matériau à base de résine époxyde est un circuit imprimé.

10. Procédé selon l'une quelconque des revendications 1 à 9, comprenant en outre, précédemment à l'étape de glycolyse, une étape de broyage du matériau à base de résine époxyde.

11. Procédé selon l'une quelconque des revendications 1 à 10, comprenant en outre, simultanément à l'étape de glycolyse, une étape de distillation des produits issus de la dégradation du polyalcool.

12. Procédé selon l'une quelconque des revendications 1 à 11, comprenant en outre une étape de séparation des produits solides et du glycolysat liquide obtenus à l'issue de l'étape de glycolyse.

13. Procédé selon la revendication 12 comprenant en outre une étape de lavage, après l'étape de séparation, à l'aide d'un solvant de lavage compatible avec le glycolysat, notamment un polyalcool, un solvant polaire comme le diméthylsulfoxyde, le diméthylformamide ou l'alcool benzylique.

14. Procédé selon l'une quelconque des revendications 1 à 13, comprenant en outre les étapes suivantes :
- glycolyse d'un matériau à base de polyéthylènetéréphtalate, par un premier glycolysat obtenu à l'issue de l'étape de glycolyse du matériau à base de résine époxyde, afin d'obtenir un second glycolysat,
- préparation de mousse polyuréthanne à partir du second glycolysat.

15. Procédé selon la revendication 9, comprenant les étapes successives de :
- retirer les composant électroniques du circuit imprimé,
- éventuellement découper ou broyer le circuit imprimé jusqu'à atteindre des morceaux de surface comprise entre 20 cm² et 1 mm²,
- glycolyser le circuit imprimé à une température supérieure à 225°C, en présence d'au moins un polyalcool et de 10 à 25% de KOH en poids par rapport au poids de matériau afin d'obtenir un premier glycolysat,
- éventuellement distiller les produits issus de la dégradation du polyalcool, concomitamment à l'étape de glycolyse,
- séparer les produits solides et le premier glycolysat liquide obtenus à l'issue de l'étape de glycolyse,
- laver les produits solides à l'aide d'un solvant compatible avec le glycolysat,
- glycolyse d'un matériau à base de polyéthylènetéréphtalate, éventuellement préalablement broyé, par le premier glycolysat obtenu à l'issue de l'étape de glycolyse du matériau à base de résine époxyde afin d'obtenir un second glycolysat,
- préparation de mousse polyuréthanne à partir du second glycolysat obtenu à l'étape précédente.
